# EUROPÄISCHE PATENTSCHRIFT

(11) **EP 0 849 601 B1**
(45) Veröffentlichungstag und Bekanntmachung des Hinweises auf die Patenterteilung: **10.01.2007**
(21) Anmeldenummer: 97120612.3
(22) Anmeldetag: 25.11.1997
(51) Int. Cl.: G01R 29/18

(54) **Vorrichtung und Verfahren zur Bestimmung des Vorzeichens einer Phasenverschiebung zweier elektrischer Signale**
Device and procedure for determining the sign of a phase shift between two electrical signals
Appareil et procédé pour déterminer le signe d'un décalage de phase entre deux signaux électriques

(30) Priorität: 20.12.1996 DE 19653323
(43) Veröffentlichungstag der Anmeldung: 24.06.1998
(73) Patentinhaber: Ch. Beha GmbH Technische Neuentwicklungen, 79286 Glottertal (DE)
(72) Erfinder: Hofstetter, Christoph, 79336 Wagenstadt (DE)
(74) Vertreter: Patentanwälte Westphal, Mussgnug & Partner

(56) Entgegenhaltungen:
- DE-A- 3 117 284
- GB-A- 2 059 078
- US-A- 4 246 497
- US-A- 4 710 703

## Beschreibung

Die vorliegende Erfindung betrifft eine Vorrichtung zur Bestimmung des Vorzeichens einer Phasenverschiebung eines ersten und zweiten im wesentlichen identischen periodischen elektrischen Signals auf einem entsprechenden ersten und zweiten elektrischen Leiter, insbesondere zur Bestimmung der Drehfeldrichtung in einem Dreiphasennetz, gemäß den Merkmalen des Oberbegriffs des Anspruchs 1.

Eine solche Vorrichtung ist z.B. aus US-A-4 246 497 bekannt.

Ohne Beschränkung ihrer allgemeinen Anwendbarkeit auf beliebige elektrische Signale werden die vorliegende Erfindung und die ihr zugundeliegende Problematik anhand der Drehfeldrichtungs und -verfahren für Dreiphasennetze näher erläutert.

Im Stand der Technik sind eine ganze Reihe verschiedener Drehfeldrichtungs-Bestimmungsvorrichtungen und entsprechende Verfahren für Dreiphasennetze bekannt.

Drehfeldrichtungs-Bestimmungsvorrichtungen werden immer dann eingesetzt, wenn die drei jeweils um 120° verschobenen sinusförmigen Signale eines Dreiphasennetzes bzw. Drehstromnetzes nicht eindeutig den vorhandenen Leitern zugeordnet werden können. Beim Anschluß von Drehstromaggregaten, wie z.B. Drehstrommotoren, muß die Phasenfolge nämlich an allen Anschlüssen stimmen, damit das Aggregat ordnungsgemäß funktioniert.

Aus der DE 40 02 603 A1 ist ein Meßgerät bekannt, mit dem die Summe der Spannungen zweier Phasen über einen Erdungskontakt gegenüber Erde gemessen wird.

Auch ist aus der DE 40 02 603 A1 ein Meßgerät ohne Erdungskontakt bekannt, welcher eine in einem Handgriff angeordnete Ableitfahne aufweist, die mit einem Referenzpotential verbindbar ist. Die Ableitfahne verläuft parallel zu dem Handgriff einer von zwei Prüfspitzen und wirkt beim Meßbetrieb zusammen mit der den Handgriff umgreifenden Hand eines Benutzers als Kondensator gegen Erde.

Erdungskontakte und Ableitfahnen sind problematisch, da sie eine feste Berührung durch den Benutzer erfordern. Weiterhin können die Länge oder die räumliche Anordnung einer Verbindungsleitung von Erdungskontakten oder Ableitfahnen Schwierigkeiten machen, da durch sie die zur Bestimmung der Drehrichtung genutzten kapazitiver Ströme derart beeinflußt werden können, daß sie zur Durchführung der Messung nicht größenmäßig nicht mehr ausreichen.

Aus der DE 31 17 284 A1 ist eine Schaltungsanordnung zur Überwachung eines symmetrischen Dreiphasenstroms bekannt. Diese weist für jeden Leiter des Dreiphasensystems einen Nulldurchgangsdetektor auf, welcher bei einem jeweiligen Nulldurchgang einen entsprechenden Impuls erzeugt. Diese Impulse werden einer Drehfeldüberwachungsschaltung zugeführt, die feststellt, ob zwischen zwei Nulldurchgangsimpulsen, die zwei aufeinanderfolgend angeschlossenen Phasen zugeordnet sind, ein Nulldurchgangsimpuls der dritten Phase auftritt. Ist dies der Fall, dann liegt eine falsche Zuordnung vor. Eine Bestimmung der Drehfeldrichtung ist mit dieser bekannten Schaltungsanordnung nicht möglich, da sie lediglich mittels einer Logikeinrichtung ermittelt, ob überhaupt ein Nulldurchgang der dritten Phase vorliegt.

Daher ist es Aufgabe der vorliegenden Erfindung, eine Vorrichtung zur Bestimmung des Vorzeichens einer Phasenverschiebung zweier elektrischer Signale der eingangs genannten Art bereitzustellen, welche eine zuverlässige und einfache Bestimmung der Vorzeichens der Phasenverschiebung bzw. der Drehfeldrichtung ermöglichen.

Erfindungsgemäß wird diese Aufgabe durch die in den Ansprüchen 1, 5 and 9 angegebene Vorrichtungen gelöst,

Weiterbildungen sind Gegenstand der Unteransprüche.

Besonders vorteilhaft an der erfindungsgemäßen Vorrichtung ist ihre sichere Funktionsweise, die nicht von einem bestimmten Erdungskontakt bzw. einer Ableitfahne abhängt. Das Meßergebnis läßt sich einfach und eindeutig angeben. Der Aufbau ist einfach und übersichtlich realisierbar und kann sich im wesentlichen auf zwei Prüfspitzen, eine Mikroelektronik, z.B. einen Mikroprozessor, und zwei Leuchten, z.B. LEDs, beschränken.

Insbesondere läßt sich mit der erfindungsgemäßen Vorrichtung die Drehfeldrichtung in einem Dreiphasennetz durch eine Messung an zwei beliebigen der drei vorhandenen Außenleiter bestimmen, denn die Phasenlage des dritten Außenleiters ergibt sich daraus automatisch.

Gemäß einer bevorzugten Weiterbildung ist die Triggereinrichtung derart gestaltet, daß sie einen vorbestimmten, z.B. einen ansteigenden, Nulldurchgang des ersten Signals als zeitlichen Bezugspunkt festlegt.

Gemäß einer weiteren bevorzugten Weiterbildung ist die Bestimmungseinrichtung derart gestaltet ist, daß sie das Vorzeichen der Phasenverschiebung aus dem Vorzeichen des zweiten Signals am zeitlichen Bezugspunkt bestimmt.

Gemäß der ersten Alternative der Erfindung weist die Triggereinrichtung eine erste Komparatoreinrichtung zum Empfangen des ersten Signals und Vergleichen desselben mit einem vorbestimmten Referenzpotential und eine Differenzierereinrichtung zum Differenzieren des Ausgangssignals der ersten Komparatoreinrichtung auf. Weiterhin weist die Bestimmungseinrichtung eine zweite Komparatoreinrichtung zum Empfangen des zweiten Signals und Vergleichen desselben mit dem vorbestimmten Referenzpotential und eine Speichereinrichtung zum Empfangen des Ausgangssignals der zweiten Komparatoreinrichtung und des Ausgangssignals der Differenzierereinrichtung auf. Dabei ist die Speichereinrichtung derart gestaltet, daß sie bei jedem Ausgangssignal der Differenzierereinrichtung mit einem vorbestimmten Vorzeichen das Vorzeichen des Ausgangssignals der zweiten Komparatoreinrichtung speichert.

Gemäß einer bevorzugten Weiterbildung weist die Speichereinrichtung eine Flip-Flop-Einrichtung auf.

Gemäß einer weiteren bevorzugten Weiterbildung ist die Triggereinrichtüng derart gestaltet, daß sie eine einem vorbestimmten, z.B. einem ansteigenden, Nulldurchgang des ersten Signals folgende halbe Signal periode des ersten Signals als zeitliches Bezugsfenster festlegt.

Dabei ist vorzugsweise die Bestimmungseinrichtung derart gestaltet, daß sie das Vorzeichen der Phasenverschiebung durch Ermitteln, ob das zweite Signal innerhalb des zeitlichen Bezugsfensters einen vorbestimmten, z.B. einen abfallenden, Nulldurchgang aufweist, bestimmt.

Gemäß der zweiten Alternative der Erfindung weist die Triggereinrichtung eine erste Komparatoreinrichtung zum Empfangen des ersten Signals und Vergleichen desselben mit einem vorbestimmten Referenzpotential und eine Differenzierereinrichtung zum Differenzieren des Ausgangssignals der ersten Komparatoreinrichtung sowie eine Zeitfenster-Erzeugungseinrichtung zum Empfangen des Ausgangssignals der Differenzierereinrichtung und Erzeugen eines Zeitfenstersignals bei jedem Ausgangsimpuls der Differenzierereinrichtung mit einem vorbestimmten Vorzeichen auf. Die Bestimmungseinrichtung weist eine zweite Komparatoreinrichtung zum Empfangen des zweiten Signals und Vergleichen desselben mit dem vorbestimmten Referenzpotential und eine Speichereinrichtung zum Empfangen des Zeitfenstersignals der Zeitfenster-Erzeugungseinrichtung und des Ausgangssignals der zweiten Komparatoreinrichtung auf. Dabei ist die Speichereinrichtung derart gestaltet, daß sie das Auftreten des vorbestimmten Nulldurchgangs des zweiten Signals innerhalb des zeitlichen Bezugsfensters speichert.

Bevorzugt weist die Speichereinrichtung eine Schmitt-Trigger-Einrichtung auf.

Gemäß einer weiteren bevorzugten Weiterbildung ist die Triggereinrichtung derart gestaltet, daß sie eine vorbestimmte z.B. positive, Halbwelle der ersten Signals als zeitliches Bezugsfenster festlegt.

Dabei ist bevorzugt die Bestimmungseinrichtung derart gestaltet, daß sie zumindest das zweite Signal digitalisiert und speichert und das Vorzeichen der Phasenverschiebung durch Ermitteln, ob das digitalisierte zweite Signal innerhalb des zeitlichen Bezugsfensters eine vorbestimmte, z.B. eine abfallende, Flanke aufweist, bestimmt.

Gemäß der dritten Alternative der Erfindung weist die Triggereinrichtung eine erste Komparatoreinrichtung zum Empfangen des ersten Signals und Vergleichen desselben mit einem vorbestimmten Referenzpotential auf. Die Bestimmungseinrichtung weist eine zweite Komparatoreinrichtung zum Empfangen des zweiten Signals und Vergleichen desselben mit dem vorbestimmten Referenzpotential und eine Logikverarbeitungseinrichtung zum Empfangen des Ausgangsssignals der ersten Komparatoreinrichtung und der zweiten Komparatoreinrichtung auf. Dabei ist die Logikverarbeitungseinrichtung derart gestaltet, daß sie das Vorzeichen der Phasenverschiebung durch Ermitteln, ob das zweite Signal eine vorbestimmte Flanke aufweist, wenn das Ausgangssignal der ersten Komparatoreinrichtung einen vorbestimmten Zustand einnimmt, bestimmt.

Gemäß einer bevorzugten Weiterbildung ist eine Anzeigeeinrichtung, die mit der Bestimmungseinrichtung verbunden ist, zum Anzeigen des bestimmten Vorzeichens der Phasenverschiebung vorgesehen. In einem besonders bevorzugten Fall ist die Anzeigeeinrichtung eine Leuchte, z.B. eine LED.

Gemäß einer weiteren bevorzugten Weiterbildung ist die Abgriffseinrichtung derart gestaltet, daß ausschließlich resistive Bauteile zum Abgriff des ersten und zweiten Signals vorgesehen sind. Damit können Blindwiderstände keinen Einfluß auf die Messung ausüben.

Gemäß einer weiteren bevorzugten Weiterbildung sind der erste und zweite elektrische Leiter mit einem gemeinsamen Schaltungspunkt, der auf einem bestimmten Potential liegt, verbunden. Vorteilhafterweise kann die Ankopplung des gemeinsamen Schaltungspunkts an das Referenzpotential auf nahezu beliebige Art erfolgen.

Gemäß einer weiteren bevorzugten Weiterbildung ist der gemeinsame Schaltungspunkt während der Bestimmung des Vorzeichens der Phasenverschiebung mit dem Erdpotential verbindbar.

Gemäß einer weiteren bevorzugten Weiterbildung ist zur Verbindung des gemeinsamen Schaltungspunkts mit dem Erdpotential eine galvanische Verbindungseinrichtung vorgesehen.

Gemäß einer weiteren bevorzugten Weiterbildung ist zur Verbindung des gemeinsamen Schaltungspunkts mit dem Erdpotential eine resistive, über eine Berührungselektrode und den menschlichen Körper verlaufende Verbindungseinrichtung vorgesehen.

Gemäß einer weiteren bevorzugten Weiterbildung ist zur Verbindung des gemeinsamen Schaltungspunkts mit dem Erdpotential eine kapazitive, über den menschlichen Körper verlaufende Verbindungseinrichtung vorgesehen.

Im Folgenden wird die vorliegende Erfindung anhand bevorzugter Ausführungsformen mit Bezug auf die begleitenden Zeichnungen näher erläutert.

In den Figuren zeigen:
- Fig. 1: eine schematische Übersicht über drei bevorzugte Ausführungsformen der Vorrichtung gemäß der vorliegenden Erfindung;
- Fig. 2: eine schematische Darstellung der ersten bevorzugten Ausführungsform der Vorrichtung gemäß der vorliegenden Erfindung;
- Fig. 3: Diagramme der phasenverschobenen Signale zweier elektrischer Leiter zur Erläuterung der ersten Ausführungsform gemäß Fig. 2, nämlich Fig. 3.1 den Fall, bei dem das Signal auf dem ersten Leiter demjenigen auf dem zweiten Leiter vorausläuft, und Fig. 3.2 den Fall, bei dem das Signal auf dem zweiten Leiter demjenigen auf dem ersten Leiter vorausläuft;
- Fig. 4: eine schematische Darstellung der zweiten bevorzugten Ausführungsform der Vorrichtung gemäß der vorliegenden Erfindung;
- Fig. 5: Diagramme der phasenverschobenen Signale zweier elektrischer Leiter zur Erläuterung der zweiten Ausführungsform gemäß Fig. 4, nämlich Fig. 5.1 den Fall, bei dem das Signal auf dem ersten Leiter demjenigen auf dem zweiten Leiter vorausläuft, und Fig. 5.2 den Fall, bei dem das Signal auf dem zweiten Leiter demjenigen auf dem ersten Leiter vorausläuft;
- Fig. 6: eine schematische Darstellung der dritten bevorzugten Ausführungsform der Vorrichtung gemäß der vorliegenden Erfindung; und
- Fig. 7: Diagramme der phasenverschobenen Signale zweier elektrischer Leiter zur Erläuterung der zweiten Ausführungsform gemäß Fig. 6, nämlich Fig. 7.1 den Fall, bei dem das Signal auf dem ersten Leiter demjenigen auf dem zweiten Leiter vorausläuft, und Fig. 7.2 den Fall, bei dem das Signal auf dem zweiten Leiter demjenigen auf dem ersten Leiter vorausläuft.

In den Figuren bezeichnen gleiche Bezugszeichen gleiche oder funktionsgleiche Bestandteile.

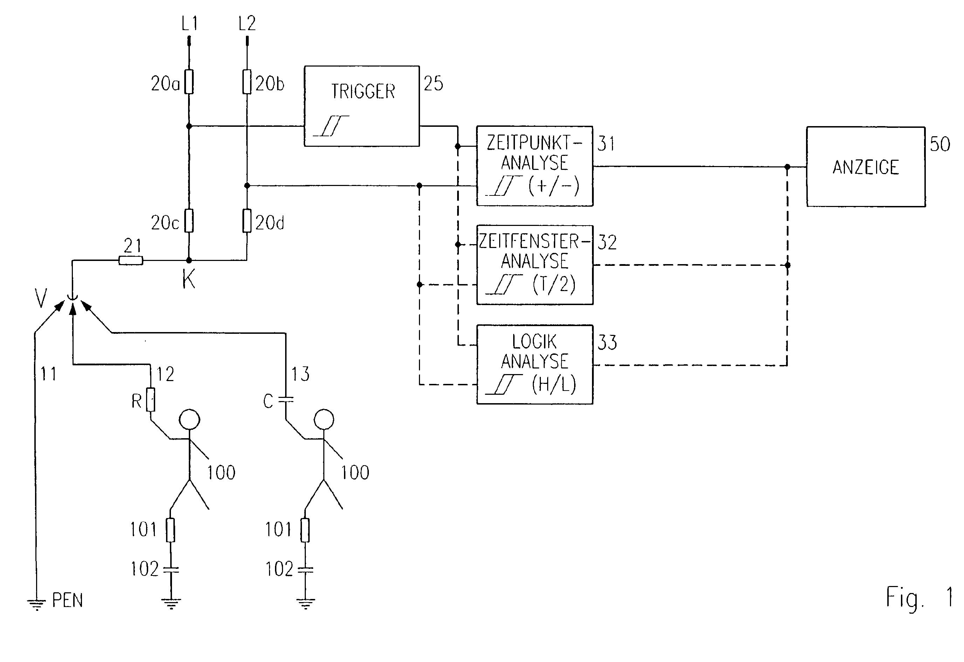

Fig. 1 zeigt eine schematische Übersicht über drei bevorzugte Ausführungsformen der Vorrichtung gemäß der vorliegenden Erfindung.

In Fig. 1 bezeichnen Bezugszeichen L1 und L2 einen ersten und zweiten elektrischen Leiter, welche ein erstes und zweites im wesentlichen identisches sinusförmiges elektrisches Signal führen, wobei die beiden Signale eine bestimmte Phasenverschiebung zueinander aufweisen. Diese Phasenverschiebung liegt im Bereich zwischen -180° und +180° (-π und +π). Die erfindungsgemäße Vorrichtung dient zur Bestimmung, welches Vorzeichen die Phasenverschiebung aufweist, d.h. welches der beiden Signale dem anderen vorausläuft bzw. hinterherläuft.

Die beiden elektrischen Leiter weisen interne oder extern eingefügte Widerstände 20a, 20b, 20c und 20d auf und sind an einem gemeinsamen Schaltungspunkt K miteinander verbunden, welcher auf einem vorbestimmten Potential liegt und über einen weiteren derartigen Widerstand 21 mit einem Verbindungspunkt V verbunden ist.

Ausgehend von dem Verbindungspunkt V kann eine Verbindung des gemeinsamen Schaltungspunkts K mit dem Erdpotential PEN über dreierlei verschiedene Arten von Verbindungseinrichtung 11, 12 und 13 erfolgen.

Bezugszeichen 11 bezeichnet eine Verbindungseinrichtung zur Verbindung des gemeinsamen Schaltungspunkts K mit dem Erdpotential PEN über eine galvanische Verbindungsleitung.

Bezugszeichen 12 bezeichnet eine Verbindungseinrichtung zur Verbindung des gemeinsamen Schaltungspunkts K mit dem Erdpotential PEN über eine resistive, über eine Berührungselektrode und den menschlichen Körper 100 verlaufende Verbindungsleitung. Dabei bezeichnen R und 101 einen jeweiligen Widerstand und 102 eine Kapazität.

Bezugszeichen 13 bezeichnet eine Verbindungseinrichtung zur Verbindung des gemeinsamen Schaltungspunkts K mit dem Erdpotential PEN über eine kapazitive, über den menschlichen Körper 100 verlaufende Verbindungsleitung. Dabei bezeichnen C und 102 eine jeweilige Kapazität und 101 einen Widerstand.

Bezugszeichen 25 bezeichnet eine Triggereinrichtung zum Empfangen des abgegriffenen ersten Signals des ersten Leiters L1. Die Triggereinrichtung legt einen zeitlichen Bezugspunkt und/oder ein zeitliches Bezugsfenster innerhalb der Signalperiode des ersten Signals fest und gibt ein entsprechendes Triggersignal aus.

Nun lassen sich drei Fälle gemäß der drei bevorzugten Ausführungsformen unterscheiden, wobei die in Fig. 1 gezeigte erste Ausführungsform mit durchgezogenen Linien und die zweite und dritte Ausführungsform mit gestrichelten Linien angedeutet sind.

Bei der ersten Ausführungsform erzeugt die Triggereinrichtung 25 zu einer beliebig definierbaren, aber konstanten Phasenlage des ersten Signals, z.B. bestimmter Nulldurchgang oder Maximum oder Minimum oder bestimmte Steigung, einen Zeitpunktimpuls.

Dieser Zeitpunktimpuls wird an eine Bestimmungseinrichtung 31 geleitet, welche die Polarität des zweiten Signals zum Zeitpunkt des Zeitpunktimpulses erfaßt und daraus das Vorzeichen der Phasenverschiebung ermittelt, also eine Zeitpunktanalyse durchführt.

Bei der zweiten Ausführungsform erzeugt die Triggereinrichtung 25 zu einer beliebig definierbaren, aber konstanten Phasenlage des ersten Signals, z.B. bestimmter Nulldurchgang oder Maximum oder Minimum oder bestimmte Steigung, einen Zeitfensterimpuls für die Dauer einer halben Signalperiode des ersten Signals.

Dieser Zeitfensterimpuls wird an eine Bestimmungseinrichtung 32 geleitet, welche erfaßt, ob das zweite Signals während der Dauer des Zeitfensterimpulses einen vorbestimmten Nulldurchgang aufweist, und daraus das Vorzeichen der Phasenverschiebung ermittelt, also eine Zeitfensteranalyse durchführt.

Bei der dritten Ausführungsform erzeugt die Triggereinrichtung 25 ebenfalls einen Zeitfensterimpuls für die Dauer einer halben Signalperiode des ersten Signals, wobei dieser mit einem bestimmten Vorzeichen des ersten Signals zusammenfällt.

Dieser Zeitfensterimpuls wird an eine Bestimmungseinrichtung 33 geleitet, welcher ebenfalls das zweite Signal in digitalisierter Form zugeleitet wird. Diese Bestimmungseinrichtung 33 erfaßt, ob das zweite Signal während des Zeitfensterimpulses eine vorbestimmte Flanke aufweist, und ermittelt daraus das Vorzeichen der Phasenverschiebung, führt also eine Logikanalyse durch.

Nach der Bestimmung des Vorzeichens der Phasenverschiebung wird dieses bei allen drei Ausführungsformen auf einer Anzeige 50, z.B. einem Bildschirm oder einer LCD-Anzeige, angezeigt.

Im Folgenden werden diese drei Ausführungsformen einzeln detailliert erläutert.

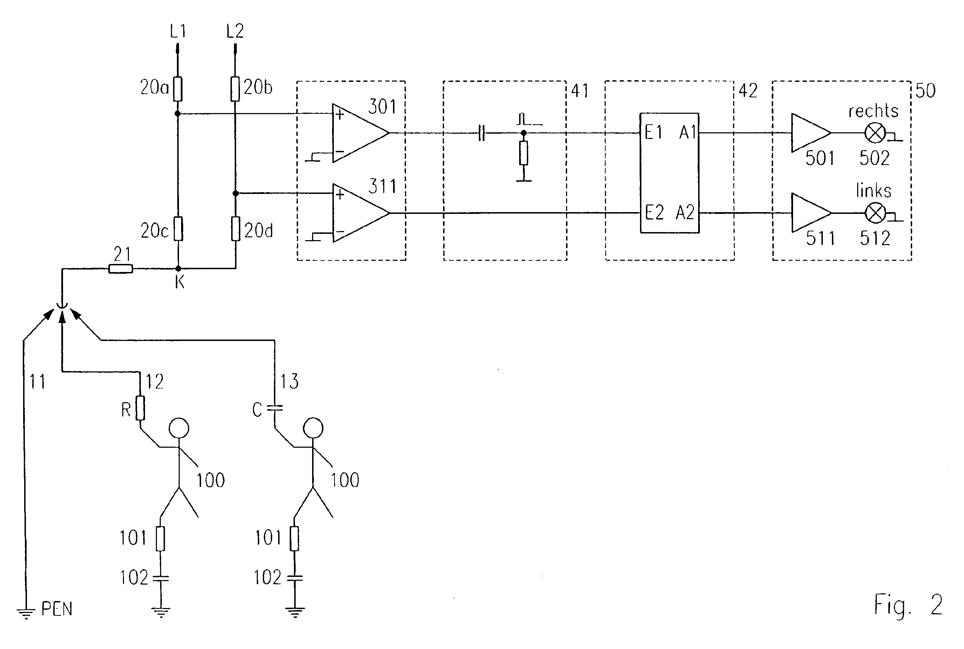

Fig. 2 zeigt eine schematische Darstellung der ersten bevorzugten Ausführungsform der Vorrichtung gemäß der vorliegenden Erfindung.

Die Triggereinrichtung weist bei der ersten Ausführungsform einen ersten Komparator 301 zum Empfangen des ersten Signals und Vergleichen desselben mit einem vorbestimmten Referenzpotential, zweckmäßigerweise Erdpotential, und einen Differenzierer 41 zum Differenzieren des Ausgangssignals des ersten Komparators 301 auf.

Die Bestimmungseinrichtung weist bei der ersten Ausführungsform einen zweiten Komparator 311 zum Empfangen des zweiten Signals und Vergleichen desselben mit dem vorbestimmten Referenzpotential und eine Speichereinrichtung 42 zum Empfangen des Ausgangssignals des Differenzierers 41 an einem Eingang E1 und des Ausgangssignals des zweiten Komparators 311 an einem Eingang E2 auf.

Die Speichereinrichtung 42 ist derart gestaltet, daß sie bei jedem Ausgangsimpuls des Differenzierers 41 mit einem positiven Vorzeichen das Vorzeichen des Ausgangssignals des zweiten Komparators 311 speichert. Natürlich könnten auch die Ausgangsimpulse des Differenzierers 41 mit negativem Vorzeichen zu diesem Zweck verwendet werden. Zweckmäßigerweise umfaßt die Speichereinrichtung 42 dazu eine Flip-Flop-Einrichtung.

Die Speichereinrichtung 42 weist zwei Ausgänge A1 und A2 auf, die mit der Anzeige 50 verbunden sind. Der erste Ausgang A1 aktiviert eine "rechte" Anzeige 501, 502 zum Anzeigen einer Rechtsverschiebung des zweiten Signals gegenüber dem ersten Signal, d.h. eines negativen Vorzeichens der Phasenverschiebung. Der zweite Ausgang A2 aktiviert eine "linke" Anzeige 511, 512 zum Anzeigen einer Linksverschiebung des zweiten Signals gegenüber dem ersten Signal, d.h. eines positiven Vorzeichens der Phasenverschiebung.

Im gezeigten Fall besteht die Anzeige 50 jeweils aus einem Treiber 501, 511 und einer davon angesteuerten Leuchte 502, 512.

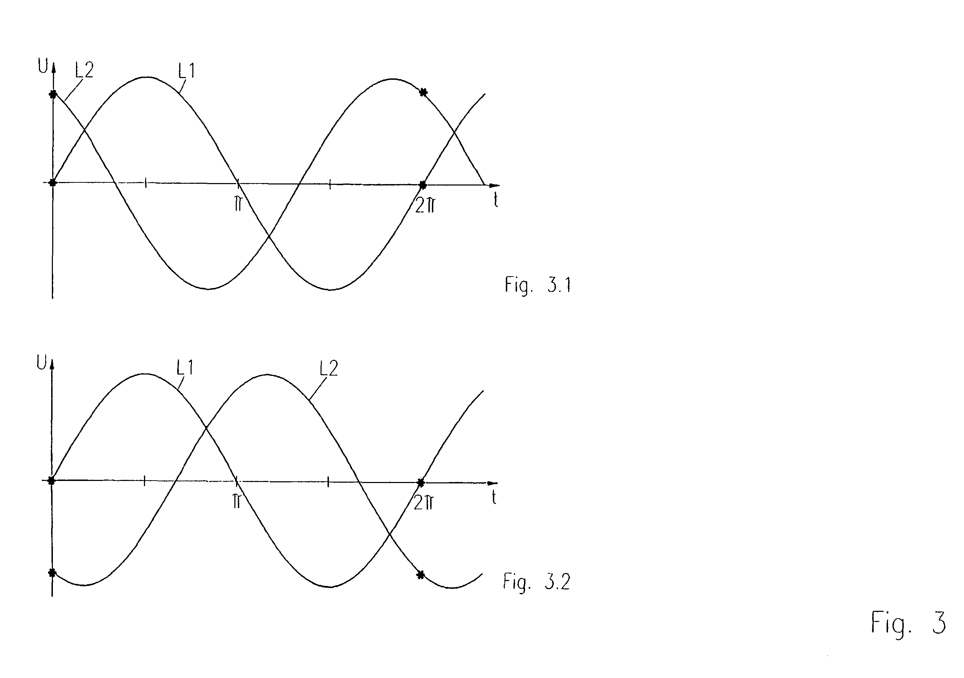

Fig. 3 zeigt Diagramme der phasenverschobenen Signale der zwei elektrischen Leiter L1, L2 zur Erläuterung der ersten Ausführungsform gemäß Fig. 2. Dabei ist auf der Abszisse die Zeit und auf der Ordinate die jeweilige Signalamplitude aufgetragen.

Fig. 3.1 zeigt den Fall, bei dem das erste Signal auf dem ersten Leiter L1 dem zweiten Signal auf dem zweiten Leiter L2 vorausläuft.

Wie in Fig. 3.1 durch hervorgehobene Punkte im Signalverlauf des ersten Signals angedeutet, gibt der Differenzierer 41 jedesmal bei einem ansteigenden Nulldurchgang des ersten Signals einen positiven Impuls aus, denn immer dann ändert sich das Signal des Komparators 301 mit ansteigender Flanke.

Aufgrund des positiven Vorzeichens der Phasenverschiebung ist zum Zeitpunkt des positiven Impulses das zweite Signal immer positiv, was von der Speichereinrichtung 42 aus dem Ausgangssignal des zweiten Komparators 311 erfaßt, gespeichert und über den Ausgang A2 zur Anzeige 50 gebracht wird, bei der demzufolge die linke Leuchte 512 aufleuchtet.

Fig. 3.2 zeigt den Fall, bei dem das zweite Signal auf dem zweiten Leiter L2 dem ersten Signal auf dem ersten Leiter L1 vorausläuft.

Aufgrund des negativen Vorzeichens der Phasenverschiebung ist zum Zeitpunkt des positiven Impulses, der durch hervorgehobene Punkte im Signalverlauf des ersten Signals angedeutet ist, das zweite Signal immer negativ, was von der Speichereinrichtung 42 aus dem Ausgangssignal des zweiten Komparators 311 erfaßt, gespeichert und über den Ausgang A1 zur Anzeige 50 gebracht wird, bei der demzufolge die rechte Leuchte 502 aufleuchtet.

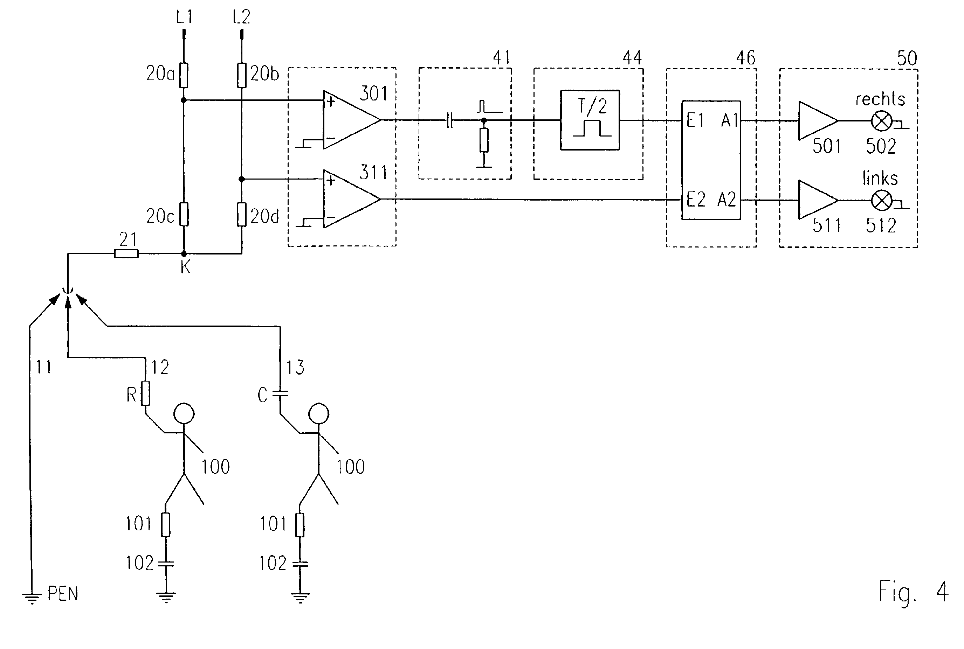

Fig. 4 zeigt eine schematische Darstellung der zweiten bevorzugten Ausführungsform der Vorrichtung gemäß der vorliegenden Erfindung.

Die Triggereinrichtung weist bei der zweiten Ausführungsform ebenfalls einen ersten Komparator 301 zum Empfangen des ersten Signals und Vergleichen desselben mit einem vorbestimmten Referenzpotential, zweckmäßigerweise Erdpotential, und einen Differenzierer 41 zum Differenzieren des Ausgangssignals des ersten Komparators auf.

Zusätzlich zur in Fig. 2 gezeigten ersten Ausführungsform umfaßt die Triggereinrichtung eine Zeitfenster-Erzeugungseinrichtung 44, zweckmäßigerweise einen Monoflop, zum Empfangen des Ausgangssignals des Differenzierers 41 und Erzeugen eines Zeitfenstersignals bei jedem Ausgangsimpuls des Differenzierers 41 mit einem positiven Vorzeichen. Natürlich kann das Zeitfenster auch ansprechend auf einen Ausgangsimpuls des Differenzierers 41 mit einem negativen Vorzeichen erzeugt werden.

Die Bestimmungseinrichtung weist bei der zweiten Ausführungsform ebenfalls einen zweiten Komparator 311 zum Empfangen des zweiten Signals und Vergleichen desselben mit dem vorbestimmten Referenzpotential und eine Speichereinrichtung 46 zum Empfangen des Ausgangssignals der Zeitfenster-Erzeugungseinrichtung 44 an einem ersten Eingang E1 und des Ausgangssignals des zweiten Komparators an einem zweiten Eingang E2 auf.

Die Speichereinrichtung 46 ist derart gestaltet, daß sie das Auftreten eines abfallenden Nulldurchgangs des zweiten Signals innerhalb des zeitlichen Bezugsfensters speichert. Zweckmäßigerweise umfaßt die Speichereinrichtung 46 dazu eine Schmitt-Trigger-Einrichtung. Natürlich könnte sie auch das Auftreten eines ansteigenden Nulldurchganges speichern.

Die übrigen Bestandteile der zweiten Ausführungsform entsprechen denen der oben erläuterten ersten Ausführungsform.

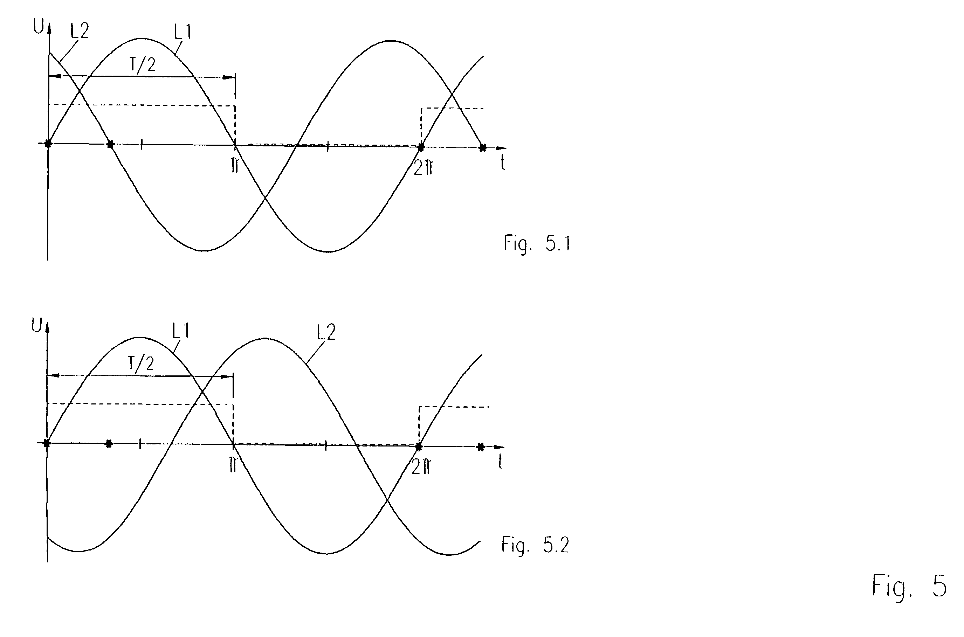

Fig. 5 zeigt Diagramme der phasenverschobenen Signale der zwei elektrischen Leiter L1, L2 zur Erläuterung der zweiten Ausführungsform gemäß Fig. 4. Dabei ist auf der Abszisse die Zeit und auf der Ordinate die jeweilige Signalamplitude aufgetragen.

Fig. 5.1 zeigt den Fall, bei dem das erste Signal auf dem ersten Leiter L1 dem zweiten Signal auf dem zweiten Leiter L2 vorausläuft.

Wie in Fig. 5.1 durch hervorgehobene Punkte im Signalverlauf des ersten Signals angedeutet, gibt der Differenzierer 41 jedesmal bei einem ansteigenden Nulldurchgang des ersten Signals einen positiven Impuls aus, denn immer dann ändert sich das Signal des Komparators 301 mit ansteigender Flanke.

Darauf ansprechend erzeugt, wie in Fig. 5.1 durch ein sich an die hervorgehobenen Punkte anschließendes gestricheltes Zeitfenster einer halben Signalperiode T/2 des ersten Signals angedeutet, die Zeitfenster-Erzeugungseinrichtung 44 ein Zeitfenstersignal mit der Länge T/2 und legt dieses an den Eingang E1 der Speichereinrichtung 46 an.

Aufgrund des positiven Vorzeichens der Phasenverschiebung erfolgt während des Zeitfenstersignals mit der Länge T/2 immer ein abfallender Nulldurchgang des zweiten Signals, was von der Speichereinrichtung 46 aus dem Ausgangssignal des Komparators 311 erfaßt, gespeichert und über den Ausgang A2 zur Anzeige 50 gebracht wird, bei der demzufolge die linke Leuchte 512 aufleuchtet.

Fig. 5.2 zeigt den Fall, bei dem das zweite Signal auf dem zweiten Leiter L2 dem ersten Signal auf dem ersten Leiter L1 vorausläuft.

Aufgrund des negativen Vorzeichens der Phasenverschiebung erfolgt während des Zeitfenstersignals mit der Länge T/2 kein abfallender Nulldurchgang des zweiten Signals, was von der Speichereinrichtung 46 aus dem Ausgangssignal des Komparators 311 erfaßt, gespeichert und über den Ausgang A1 zur Anzeige 50 gebracht wird, bei der demzufolge die rechte Leuchte 502 aufleuchtet.

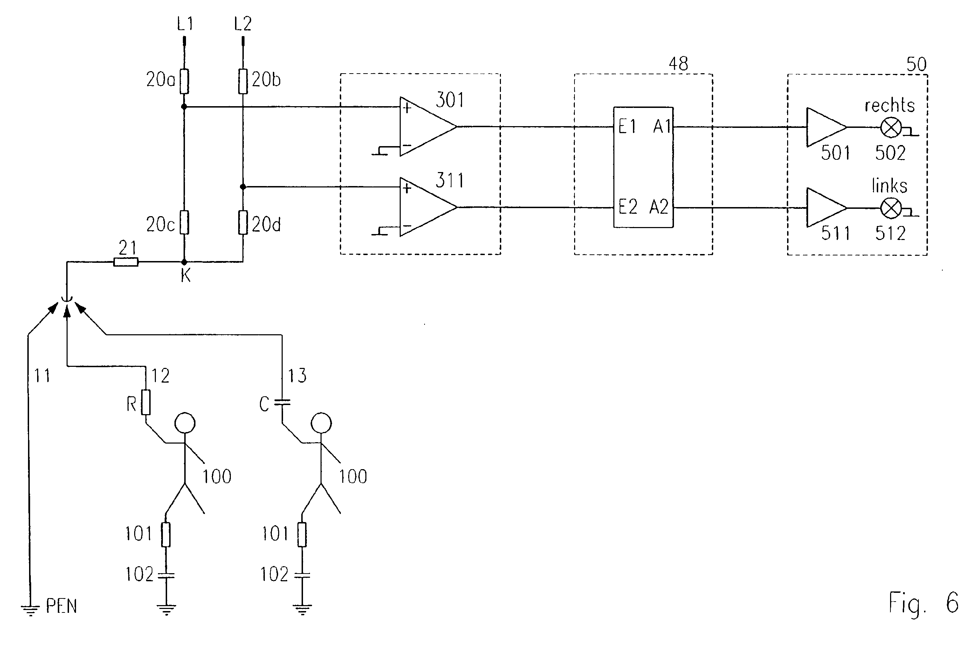

Fig. 6 zeigt eine schematische Darstellung der dritten bevorzugten Ausführungsform der Vorrichtung gemäß der vorliegenden Erfindung.

Die Triggereinrichtung weist bei der dritten Ausführungsform ebenfalls einen ersten Komparator 301 zum Empfangen des ersten Signals und Vergleichen desselben mit einem vorbestimmten Referenzpotential, zweckmäßigerweise Erdpotential, auf.

Die Bestimmungseinrichtung weist bei der dritten Ausführungsform einen zweiten Komparator 311 zum Empfangen des zweiten Signals und Vergleichen desselben mit dem vorbestimmten Referenzpotential und eine Logikverarbeitungseinrichtung 48 zum Empfangen des Ausgangsssignals des ersten Komparators 301 an einem ersten Eingang E1 und des zweiten Komparators 311 an einem zweiten Eingang E2 auf.

Die Logikverarbeitungseinrichtung 48 ist derart gestaltet, daß sie das Vorzeichen der Phasenverschiebung durch Ermitteln, ob das zweite Signal eine abfallende Flanke aufweist, wenn das Ausgangssignal des ersten Komparators 301 einen H-Zustand einnimmt, bestimmt. Natürlich kann auch das Vorhandensein einer ansteigenden Flanke ermittelt werden, und es kann auch der L-Zustand des Ausgangssignal des ersten Komparators 301 als Triggersignal verwendet werden.

Die übrigen Bestandteile der dritten Ausführungsform entsprechen denen der oben erläuterten ersten und zweiten Ausführungsform.

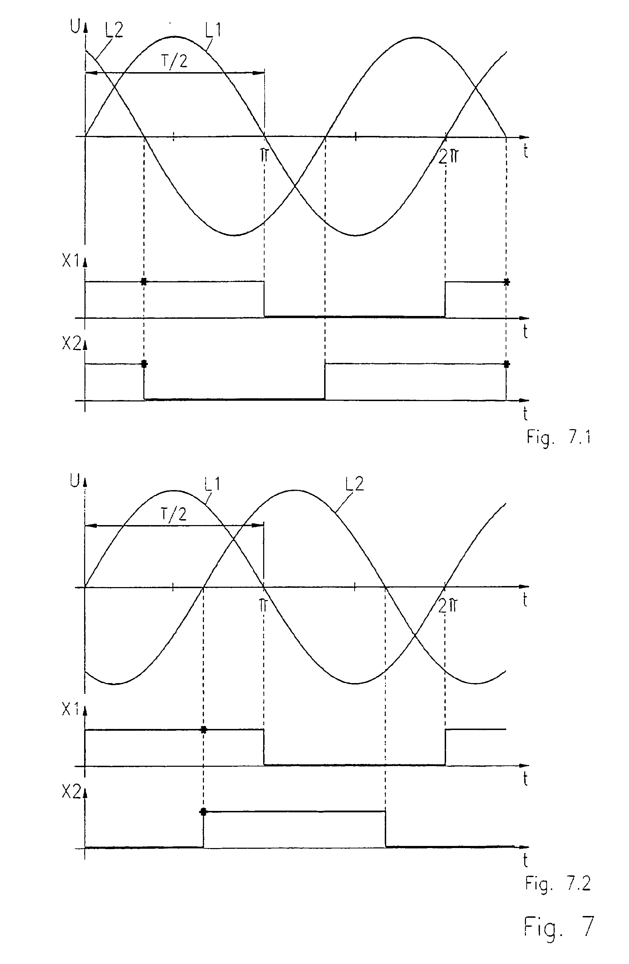

Fig. 7 zeigt Diagramme der phasenverschobenen Signale der zwei elektrischen Leiter L1, L2 zur Erläuterung der zweiten Ausführungsform gemäß Fig. 6. Dabei ist auf der Abszisse die Zeit und auf der Ordinate die jeweilige Signalamplitude aufgetragen.

Fig. 7.1 zeigt den Fall, bei dem das erste Signal auf dem ersten Leiter L1 dem zweiten Signal auf dem zweiten Leiter L2 vorausläuft.

In Fig. 7.1 bezeichnet X1 die digitalisierte Form des ersten Signals des ersten Leiters L1 entsprechend dem Ausgangssignal des ersten Komparators 301 und X2 die digitalisierte Form des zweiten Signals des zweiten Leiters L2 entsprechend dem Ausgangssignal des zweiten Komparators 311. Wie in Fig. 7.1 durch hervorgehobene Punkte im Signalverlauf des digitalisierten ersten und zweiten Signals X1, X2 angedeutet, weist das zweite digitalisierte Signal X2 während des H-Zustands des ersten digitalisierten Signals X1 aufgrund des positiven Vorzeichens der Phasenverschiebung immer eine abfallende Flanke auf. Dies wird von der Logikverarbeitungeinrichtung 48 erfaßt, gespeichert und über den Ausgang A2 zur Anzeige 50 gebracht wird, bei der demzufolge die linke Leuchte 512 aufleuchtet.

Fig. 7.2 zeigt den Fall, bei dem das zweite Signal auf dem zweiten Leiter L2 dem ersten Signal auf dem ersten Leiter L1 vorausläuft.

Wie in Fig. 7.2 durch hervorgehobene Punkte im Signalverlauf des digitalisierten ersten und zweiten Signals X1, X2 angedeutet, weist das zweite digitalisierte Signal X2 während des H-Zustands des ersten digitalisierten Signals X1 aufgrund des negativen Vorzeichens der Phasenverschiebung keine abfallende Flanke auf. Dies wird von der Logikverarbeitungeinrichtung 48 erfaßt, gespeichert und über den Ausgang A2 zur Anzeige 50 gebracht wird, bei der demzufolge die rechte Leuchte 502 aufleuchtet.

Obwohl die obige erste bis dritte Auführungsform einzeln diskutiert wurden, sind sie natürlich beliebig kombinierbar. Auch können mehrere aufeinanderfolgende Ereignisse, d.h. Messungen in aufeinanderfolgenden Signalperioden verknüpft, z.B. gemittelt, werden. Dies ist insbesondere im Falle stark verrauschter Signale von Bedeutung.

## Patentansprüche

1. **dadurch gekennzeichnet, dass**
die Triggereinrichtung (25) eine erste Komparatoreinrichtung (301) zum Empfangen des ersten Signals (21) und Vergleichen desselben mit einem vorbestimmten Referenzpotential und eine Differenzierereinrichtung (41) zum Differenzieren des Ausgangssignals der ersten Komparatoreinrichtung (301) aufweist; und
die Bestimmungseinrichtung (31) eine zweite Komparatoreinrichtung (311) zum Empfangen des zweiten Signals (22) und Vergleichen desselben mit dem vorbestimmten Referenzpotential und eine Speichereinrichtung (42) zum Empfangen des Ausgangssignals der zweiten Komparatoreinrichtung (311) und des Ausgangssignals der Differenzierereinrichtung (41) aufweist,
wobei die Speichereinrichtung (42) derart gestaltet ist, dass sie bei jedem Ausgangssignal der Differenzierereinrichtung (41) mit einem vorbestimmten Vorzeichen das Vorzeichen des Ausgangssignals der zweiten Komparatoreinrichtung (311) speichert.

2. Vorrichtung nach Anspruch 1,
**dadurch gekennzeichnet, dass** die Speichereinrichtung (42) eine Flip-Flop-Einrichtung aufweist.

3. Vorrichtung nach Anspruch 1,
**dadurch gekennzeichnet, dass** die Triggereirzrichtung (25) derart gestaltet ist, dass sie eine einem vorbestimmten Nulldurchgang des ersten Signals (21) folgende halbe Signalperiode des ersten Signals (21) als zeitliches Bezugsfenster festlegt.

4. Vorrichtung nach Anspruch 3,
**dadurch gekennzeichnet, dass** die Bestimmungseinrichtung (32) derart gestaltet ist, dass sie das Vorzeichen der Phasenverschiebung durch Ermitteln, ob das zweite Signal (22) innerhalb des zeitlichen Bezugsfensters einen vorbestimmten Nulldurchgang aufweist, bestimmt.

5. Vorrichtung zur Bestimmung des Vorzeichens einer Phasenverschiebung eines ersten und zweiten im wesentlichen identischen periodischen elektrischen Signals (21, 22) auf einem entsprechenden ersten und zweiten elektrischen Leiter, insbesondere zur Bestimmung der Drehfeldrichtung in einem Dreiphasennetz, mit: einer Abgriffseinrichtung (20a-20d) zum Abgreifen des ersten Signals (21) vom ersten Leiter und des zweiten Signals (22) vom zweiten Leiter; einer Triggereinrichtung (25) zum Empfangen des abgegriffenen ersten Signals (21) und Festlegen eines zeitlichen Bezugspunkts oder eines zeitlichen Bezugsfensters innerhalb der Signalperiode des ersten Signals (21) und Ausgeben eines entsprechenden Triggersignals; und einer Bestimmungseinrichtung (31; 32; 33) zum Empfangen des Triggersignals und des abgegriffenen zweiten Signals (22) und Bestimmen des Vorzeichens der Phasenverschiebung unter Berücksichtigung von zumindest dem Wert des zweiten Signals (22) am zeitlichen Bezugspunkt bzw. dem Verlauf des zweiten Signals innerhalb des zeitlichen Bezugsfensters,
**dadurch gekennzeichnet, dass** die Triggereinrichtung (25) eine erste Komparatoreinrichtung (301) zum Empfangen des ersten Signals (21) und Vergleichen desselben mit einem vorbestimmten Referenzpotential und eine Differenzierereinrichtung (41) zum Differenzieren des Ausgangssignals der ersten Komparatoreinrichtung (301) sowie eine Zeitfenster-Erzeugungseinrichtung(44) zum Empfangen des Ausgangssignals der Differenzierereinrichtung und Erzeugen eines Zeitfenstersignals bei jedem Ausgangssignal der Differenzierereinrichtung (41) mit einem vorbestimmten Vorzeichen aufweist; und
die Bestimmungseinrichtung (32) eine zweite Komparatoreinrichtung (311) zum Empfangen des zweiten Signals (22) und Vergleichen desselben mit dem vorbestimmten Referenzpotential und eine Speichereinrichtung (46) zum Empfangen des Zeitfenstersignals der Zeitfenster-Erzeugungseinrichtung (44) und des Ausgangssignals der zweiten Komparatoreinrichtung (311) aufweist,
wobei die Speichereinrichtung (46) derart gestaltet ist, dass sie das Auftreten eines vorbestimmten Nulldurchgangs des zweiten Signals (22) innerhalb des zeitlichen Bezugsfensters speichert.

6. Vorrichtung nach Anspruch 5,
**dadurch gekennzeichnet, dass** die Speichereinrichtung (46) eine Schmitt-Trigger-Einrichtung aufweist.

7. Vorrichtung nach Anspruch 1,
**dadurch gekennzeichnet, dass** die Triggereinrichtung (25) derart gestaltet ist, dass sie eine vorbestimmte Halbwelle der ersten Signals als zeitliches Bezugsfenster festlegt.

8. Vorrichtung nach Anspruch 7,
**dadurch gekennzeichnet, dass** die Bestimmungseinrichtung (33) derart gestaltet ist, dass sie zumindest das zweite Signal (22) digitalisiert und speichert und das Vorzeichen der Phasenverschiebung durch Ermitteln, ob das digitalisierte zweite Signal (22) innerhalb des zeitlichen Bezugsfensters eine vorbestimmte Flanke aufweist, bestimmt.

9. Vorrichtung zur Bestimmung des Vorzeichens einer Phasenverschiebung eines ersten und zweiten im wesentlichen identischen periodischen elektrischen Signals (21, 22) auf einem entsprechenden ersten und zweiten elektrischen Leiter, insbesondere zur Bestimmung der Drehfeldrichtung in einem Dreiphasennetz, mit: einer Abgriffseinrichtung (20a-20d) zum Abgreifen des ersten Signals (21) vom ersten Leiter und des zweiten Signals (22) vom zweiten Leiter; einer Triggereinrichtung (25) zum Empfangen des abgegriffenen ersten Signals (21) und Festlegen eines zeitlichen Bezugspunkts oder eines zeitlichen Bezugsfensters innerhalb der Signalperiode des ersten Signals (21) und Ausgeben eines entsprechenden Triggersignals; und einer Bestimmungseinrichtung (31; 32; 33) zum Empfangen des Triggersignals und des abgegriffenen zweiten Signals (22) und Bestimmen des Vorzeichens der Phasenverschiebung unter Berücksichtigung von zumindest dem Wert des zweiten Signals (22) am zeitlichen Bezugspunkt bzw. dem Verlauf des zweiten Signals innerhalb des zeitlichen Bezugsfensters,
**dadurch gekennzeichnet, dass**
die Triggereinrichtung (25) eine erste Komparatoreinrichtung (301) zum Empfangen des ersten Signals (21) und Vergleichen desselben mit einem vorbestimmten Referenzpotential aufweist; und
die Bestimmungseinrichtung (33) eine zweite Komparatoreinrichtung (311) zum Empfangen des zweiten Signals (22) und Vergleichen desselben mit dem vorbestimmten Reiferenzpotential und eine Logikverarbeitungseinrichtung (48) zum Empfangen des Ausgangsssignals der ersten Komparatoreinrichtung (301) und der zweiten Komparatoreinrichtung (311) aufweist,
wobei die Logikverarbeitungseinrichtung (48) derart gestaltet ist, dass sie das Vorzeichen der Phasenverschiebung durch Ermitteln, ob das zweite Signal (22) eine vorbestimmte Flanke aufweist, wenn das Ausgangssignal der ersten Komparatoreinrichtung (301) einen vorbestimmten Zustand einnimmt, bestimmt.

10. Vorrichtung nach einem der vorhergehenden Ansprüche, **gekennzeichnet durch** eine Anzeigeeinrichtung (50), die mit der Bestimmungseinrichtung (31; 32; 33) verbunden ist, zum Anzeigen des bestimmten Vorzeichens der Phasenverschiebung.

11. Vorrichtung nach einem der vorhergehenden Ansprüche,
**dadurch gekennzeichnet, dass** die Abgriffseinrichtung (20a-20d) derart gestaltet ist, dass ausschliesslich resistive Bauteile zum Abgriff des ersten (21) und zweiten Signals (22) vorgesehen sind.

12. Vorrichtung nach einem der vorhergehenden Ansprüche,
**dadurch gekennzeichnet, dass** der erste und zweite elektrische Leiter mit einem gemeinsamen Schaltungspunkt (K), der auf einem bestimmten Potential liegt, verbunden sind.

13. Vorrichtung nach Anspruch 12,
**dadurch gekennzeichnet, dass** der gemeinsame Schaltungspunkt mit dem Erdpotential verbindbar ist.

14. Vorrichtung nach Anspruch 13,
**dadurch gekennzeichnet, dass** zur Verbindung des gemeinsamen Schaltungspunkts mit dem Erdpotential eine galvanische Verbindungseinrichtung (11) vorgesehen ist.

15. Vorrichtung nach Anspruch 13,
**dadurch gekennzeichnet, dass** zur Verbindung des gemeinsamen Schaltungspunkts mit dem Erdpotential eine resistive Verbindungseinrichtung (12) vorgesehen ist, die mit einer Berührungselektrode verbunden ist bei deren Berühren die Verbindung über den Körper des Berührenden mit dem Erdpotential herstellbar ist.

16. Vorrichtung nach Anspruch 13,
**dadurch gekennzeichnet, dass** zur Verbindung des gemeinsamen Schaltungspunkts mit dem Erdpotential eine kapazitive Verbindungseinnrichtung (13) vorgesehen ist, die mit einer Berühungselektrode verbunden ist, bei deren Berühren die Verbidung über den Körper des Berührenden mit dem Erdpotential herstellbar ist.

## Claims

1. Device for determining the sign of a phase shift of a first and second essentially identical periodic electrical signal (21, 22) on a corresponding first and second electrical conductor, in particular for determining the rotating field direction in a three-phase network, comprising:
a tapping device (20a-20d) for tapping the first signal (21) from the first conductor and the second signal (22) from the second conductor;
a trigger device (25) for receiving the tapped first signal (21) and defining a temporal reference point or a temporal reference window within the signal period of the first signal (21) and outputting a corresponding trigger signal; and
a determination device (31; 32; 33) for receiving the trigger signal and the tapped second signal (22) and determining the sign of the phase shift, taking account of at least the value of the second signal (22) at the temporal reference point or the waveform of the second signal within the temporal reference window,
**characterised in that**
the trigger device (25) has a first comparator device (301) for receiving the first signal (21) and comparing said signal with a predetermined reference potential, and a differentiating device (41) for differentiating the output signal of the first comparator device (301); and
the determination device (31) has a second comparator device (311) for receiving the second signal (22) and comparing said signal with the predetermined reference potential, and a memory device (42) for receiving the output signal of the second comparator device (311) and the output signal of the differentiating device (41),
wherein the memory device (42) is designed in such a way that, for each output signal of the differentiating device (41) having a predetermined sign, it stores the sign of the output signal of the second comparator device (311).

2. Device according to Claim 1, **characterised in that** the memory device (42) has a flip-flop device.

3. Device according to Claim 1, **characterised in that** the trigger device (25) is designed in such a way that it defines, as the temporal reference window, a half signal period of the first signal (21) following a predetermined zero crossing of the first signal (21).

4. Device according to Claim 3, **characterised in that** the determination device (32) is designed in such a way that it determines the sign of the phase shift by ascertaining whether the second signal (22) has a predetermined zero crossing within the temporal reference window.

5. Device for determining the sign of a phase shift of a first and second essentially identical periodic electrical signal (21, 22) on a corresponding first and second electrical conductor, in particular for determining the rotating field direction in a three-phase network, comprising:
a tapping device (20a-20d) for tapping the first signal (21) from the first conductor and the second signal (22) from the second conductor;
a trigger device (25) for receiving the tapped first signal (21) and defining a temporal reference point or a temporal reference window within the signal period of the first signal (21) and outputting a corresponding trigger signal; and
a determination device (31; 32; 33) for receiving the trigger signal and the tapped second signal (22) and determining the sign of the phase shift, taking account of at least the value of the second signal (22) at the temporal reference point or the waveform of the second signal within the temporal reference window,
**characterised in that**
the trigger device (25) has a first comparator device (301) for receiving the first signal (21) and comparing said signal with a predetermined reference potential, and a differentiating device (41) for differentiating the output signal of the first comparator device (301), and also a time window generation device (44) for receiving the output signal of the differentiating device and generating a time window signal for each output signal of the differentiating device (41) having a predetermined sign; and
the determination device (32) has a second comparator device (311) for receiving the second signal (22) and comparing said signal with the predetermined reference potential, and a memory device (46) for receiving the time window signal of the time window generation device (44) and the output signal of the second comparator device (311),
wherein the memory device (46) is designed in such a way that it stores the occurrence of a predetermined zero crossing of the second signal (22) within the temporal reference window.

6. Device according to Claim 5, **characterised in that** the memory device (46) has a Schmitt trigger device.

7. Device according to Claim 1, **characterised in that** the trigger device (25) is designed in such a way that it defines a predetermined half-wave of the first signal as the temporal reference window.

8. Device according to Claim 7, **characterised in that** the determination device (33) is designed in such a way that it digitises and stores at least the second signal (22) and determines the sign of the phase shift by ascertaining whether the digitised second signal (22) has a predetermined flank within the temporal reference window.

9. Device for determining the sign of a phase shift of a first and second essentially identical periodic electrical signal (21, 22) on a corresponding first and second electrical conductor, in particular for determining the rotating field direction in a three-phase network, comprising:
a tapping device (20a-20d) for tapping the first signal (21) from the first conductor and the second signal (22) from the second conductor;
a trigger device (25) for receiving the tapped first signal (21) and defining a temporal reference point or a temporal reference window within the signal period of the first signal (21) and outputting a corresponding trigger signal; and
a determination device (31; 32; 33) for receiving the trigger signal and the tapped second signal (22) and determining the sign of the phase shift, taking account of at least the value of the second signal (22) at the temporal reference point or the waveform of the second signal within the temporal reference window,
**characterised in that**
the trigger device (25) has a first comparator device (301) for receiving the first signal (21) and comparing said signal with a predetermined reference potential; and
the determination device (33) has a second comparator device (311) for receiving the second signal (22) and comparing said signal with the predetermined reference potential, and a logic processing device (48) for receiving the output signal of the first comparator device (301) and of the second comparator device (311),
wherein the logic processing device (48) is designed in such a way that it determines the sign of the phase shift by ascertaining whether the second signal (22) has a predetermined flank when the output signal of the first comparator device (301) assumes a predetermined state.

10. Device according to one of the preceding claims, **characterised by** a display device (50), which is connected to the determination device (31; 32; 33), for displaying the determined sign of the phase shift.

11. Device according to one of the preceding claims, **characterised in that** the tapping device (20a-20d) is designed in such a way that exclusively resistive components are provided for tapping the first (21) and second signal (22).

12. Device according to one of the preceding claims, **characterised in that** the first and second electrical conductors are connected to a common switching point (K) which is at a given potential.

13. Device according to Claim 12, **characterised in that** the common switching point can be connected to ground potential.

14. Device according to Claim 13, **characterised in that** a galvanic connection device (11) is provided for connecting the common switching point to ground potential.

15. Device according to Claim 13, **characterised in that** a resistive connection device (12) is provided for connecting the common switching point to ground potential, which resistive connection device is connected to a contact electrode at which, when contact is made, the connection to ground potential can be established through the body of the person making contact.

16. Device according to Claim 13, **characterised in that** a capacitive connection device (13) is provided for connecting the common switching point to ground potential, which capacitive connection device is connected to a contact electrode at which, when contact is made, the connection to ground potential can be established through the body of the person making contact.

## Revendications

1. Dispositif de détermination du signe d'un décalage de phase entre des premier et deuxième signaux électriques périodiques pour l'essentiel identiques (21, 22) sur un premier et un deuxième conducteur électrique correspondants, en particulier pour la détermination du sens du champ tournant dans un réseau triphasé, comprenant :
- un dispositif de détection (20a-20d) pour détecter le premier signal (21) du premier conducteur et le deuxième signal (22) du deuxième conducteur ;
- un dispositif de déclenchement (25) pour recevoir le premier signal détecté (21) et déterminer un instant de référence ou un intervalle de temps de référence à l'intérieur de la période de signal du premier signal (21) et émettre un signal de déclenchement correspondant ; et
- un dispositif de détermination (31 ; 32 ; 33) pour recevoir le signal de déclenchement et le deuxième signal détecté (22) et déterminer le signe du décalage de phase en prenant en compte au moins la valeur du deuxième signal (22) à l'instant de référence ou le tracé du deuxième signal à l'intérieur de l'intervalle de temps de référence,
**caractérisé en ce que**
le dispositif de déclenchement (25) présente un premier dispositif comparateur (301) pour recevoir le premier signal (21) et le comparer à un potentiel de référence prédéterminé et un dispositif de différenciation (41) pour différencier le signal de sortie du premier dispositif comparateur (301) ; et
le dispositif de détermination (31) présente un deuxième dispositif comparateur (311) pour recevoir le deuxième signal (22) et le comparer au potentiel de référence prédéterminé et un dispositif de mémoire (42) pour recevoir le signal de sortie du deuxième dispositif comparateur (311) et le signal de sortie du dispositif de différenciation (41),
le dispositif de mémoire (42) étant conçu pour qu'à chaque signal de sortie du dispositif de différenciation (41) ayant un signe prédéterminé, il mémorise le signe du signal de sortie du deuxième dispositif comparateur (311).

2. Dispositif selon la revendication 1,
**caractérisé en ce que**
le dispositif de mémoire (42) présente un dispositif à bascule bistable.

3. Dispositif selon la revendication 1,
**caractérisé en ce que**
le dispositif de déclenchement (25) détermine, en tant qu'intervalle de temps de référence, une demi-période de signal du premier signal (21) suivant un passage au point zéro prédéterminé du premier signal (21).

4. Dispositif selon la revendication 3,
**caractérisé en ce que**
le dispositif de détermination (32) détermine le signe du décalage de phase en déterminant si le deuxième signal (22) présente un passage au point zéro prédéterminé à l'intérieur de l'intervalle de temps de référence.

5. Dispositif de détermination du signe d'un décalage de phase entre des premier et deuxième signaux électriques périodiques pour l'essentiel identiques (21, 22) sur un premier et un deuxième conducteur électrique correspondants, en particulier pour la détermination du sens du champ tournant dans un réseau triphasé, comprenant :
- un dispositif de détection (20a-20d) pour détecter le premier signal (21) du premier conducteur et le deuxième signal (22) du deuxième conducteur;
- un dispositif de déclenchement (25) pour recevoir le premier signal détecté (21) et déterminer un instant de référence ou un intervalle de temps de référence à l'intérieur de la période de signal du premier signal (21) et émettre un signal de déclenchement correspondant ; et
- un dispositif de détermination (31 ; 32 ; 33) pour recevoir le signal de déclenchement et le deuxième signal détecté (22) et déterminer le signe du décalage de phase en prenant en compte au moins la valeur du deuxième signal (22) à l'instant de référence ou le tracé du deuxième signal à l'intérieur de l'intervalle de temps de référence,
**caractérisé en ce que**
le dispositif de déclenchement (25) présente un premier dispositif comparateur (301) pour recevoir le premier signal (21) et le comparer à un potentiel de référence prédéterminé et un dispositif de différenciation (41) pour différencier le signal de sortie du premier dispositif comparateur (301), ainsi qu'un dispositif de génération d'intervalle de temps (44) pour recevoir le signal de sortie du dispositif de différenciation et générer un signal d'intervalle de temps à chaque signal de sortie du dispositif de différenciation (41) ayant un signe prédéterminé ; et
le dispositif de détermination (32) présente un deuxième dispositif comparateur (311) pour recevoir le deuxième signal (22) et le comparer au potentiel de référence prédéterminé et un dispositif de mémoire (46) pour recevoir le signal d'intervalle de temps du dispositif de génération d'intervalle de temps (44) et le signal de sortie du deuxième dispositif comparateur (311),
le dispositif de mémoire (46) étant conçu pour mémoriser l'apparition d'un passage au point zéro prédéterminé du deuxième signal (22) à l'intérieur de l'intervalle de temps de référence.

6. Dispositif selon la revendication 5,
**caractérisé en ce que**
le dispositif de mémoire (46) présente un dispositif à bascule de Schmitt.

7. Dispositif selon la revendication 1,
**caractérisé en ce que**
le dispositif de déclenchement (25) détermine un demi-seuil prédéterminé du premier signal en tant qu'intervalle de temps de référence.

8. Dispositif selon la revendication 7,
**caractérisé en ce que**
le dispositif de détermination (33) numérise et mémorise au moins le deuxième signal (22), et détermine le signe du décalage de phase en déterminant si le deuxième signal numérisé (22) présente une pente prédéterminée à l'intérieur de l'intervalle de temps de référence.

9. Dispositif de détermination du signe d'un décalage de phase entre des premier et deuxième signaux électriques périodiques pour l'essentiel identiques (21, 22) sur un premier et un deuxième conducteur électrique correspondants, en particulier pour la détermination du sens du champ tournant dans un réseau triphasé, comprenant :
- un dispositif de détection (20a-20d) pour détecter le premier signal (21) du premier conducteur et le deuxième signal (22) du deuxième conducteur ;
- un dispositif de déclenchement (25) pour recevoir le premier signal détecté (21) et déterminer un instant de référence ou un intervalle de temps de référence à l'intérieur de la période de signal du premier signal (21) et émettre un signal de déclenchement correspondant ; et
- un dispositif de détermination (31 ; 32 ; 33) pour recevoir le signal de déclenchement et le deuxième signal détecté (22) et déterminer le signe du décalage de phase en prenant en compte au moins la valeur du deuxième signal (22) à l'instant de référence ou le tracé du deuxième signal à l'intérieur de l'intervalle de temps de référence,
**caractérisé en ce que**
le dispositif de déclenchement (25) présente un premier dispositif comparateur (301) pour recevoir le premier signal (21) et le comparer à un potentiel de référence prédéterminé ; et
le dispositif de détermination (33) présente un deuxième dispositif comparateur (311) pour recevoir le deuxième signal (22) et le comparer au potentiel de référence prédéterminé et un dispositif de traitement logique (48) pour recevoir le signal de sortie du premier dispositif comparateur (301) et du deuxième dispositif comparateur (311),
le dispositif de traitement logique (48) étant conçu pour déterminer le signe du décalage de phase en déterminant si le deuxième signal (22) présente une pente prédéterminée lorsque le signal de sortie du premier dispositif comparateur (301) adopte un état prédéterminé.

10. Dispositif selon l'une des revendications précédentes,
**caractérisé par**
un dispositif d'affichage (50) relié au dispositif de détermination (31; 32 ; 33), pour afficher le signe déterminé du décalage de phase.

11. Dispositif selon l'une des revendications précédentes,
**caractérisé en ce que**
le dispositif de détection (20a-20d) est conçu pour uniquement des composants résistifs pour la détection du premier (21) et du deuxième (22) signaux.

12. Dispositif selon l'une des revendications précédentes,
**caractérisé en ce que**
le premier et le deuxième conducteur électrique sont reliés à un point de circuit commun (K) situé sur un potentiel déterminé.

13. Dispositif selon la revendication 12,
**caractérisé en ce que**
le point de circuit commun peut être relié à la masse.

14. Dispositif selon la revendication 13,
**caractérisé par**
un dispositif de connexion galvanique (11) pour relier le point de circuit commun à la masse.

15. Dispositif selon la revendication 13,
**caractérisé en ce que**
pour relier le point de circuit commun à la masse, un dispositif de connexion résistif (12) est relié à une électrode de contact qui, lorsqu'on la touche, permet la connexion à la masse via le corps de la personne qui la touche.

16. Dispositif selon la revendication 13,
**caractérisé en ce que**
pour relier le point de circuit commun à la masse, un dispositif de connexion capacitif (13) est relié à une électrode de contact qui, lorsqu'on la touche, permet la connexion à la masse via le corps de la personne qui la touche.
